# EUROPÄISCHE PATENTSCHRIFT

(11) **EP 2 416 064 B1**
(45) Veröffentlichungstag und Bekanntmachung des Hinweises auf die Patenterteilung: **19.12.2012**
(21) Anmeldenummer: 10172192.6
(22) Anmeldetag: 06.08.2010
(51) Int. Cl.: F21V 25/12, F21S 8/00, F21V 31/04, H01L 23/31, F21Y 101/02, F21V 15/01, H05K 3/28

(54) **Elektrische Signal-Schaltungsanordnung, vorzugsweise elektrische Signal-Leuchtenanordnung**
Electric signal switch assembly, preferably electric signal light assembly
Agencement de commutation de signal électrique, de préférence agencement de lampes à signal électrique

(43) Veröffentlichungstag der Anmeldung: 08.02.2012
(73) Patentinhaber: FHF Funke + Huster Fernsig GmbH, 45478 Mülheim an der Ruhr (DE)
(72) Erfinder: Römer, Bernhard, 47058, Duisburg (DE)
(74) Vertreter: Nunnenkamp, Jörg

(56) Entgegenhaltungen:
- EP-A1- 2 088 369
- WO-A2-02/13585
- DE-A1-102004 057 422
- DE-U1-202008 010 175
- US-A- 4 729 076

## Beschreibung

Die Erfindung betrifft eine elektrische Signal-Schaltungsanordnung, vorzugsweise eine elektrische Signal-Leuchtenanordnung, zum Einsatz in explosionsgefährdeten Bereichen, mit einem Gehäuse, und mit zumindest einem in dem Gehäuse angeordneten elektrischen Bauteil, insbesondere Leuchtmittel, wobei das Innere des Gehäuses wenigstens teilweise mit einer Vergussmasse ausgefüllt ist, und wobei wenigstens zwischen dem elektrischen Bauteil und der Vergussmasse eine temperaturbedingte Volumenänderungen ausgleichende Trennschicht vorgesehen ist.

Elektrische Signal-Schaltungsanordnungen bzw. elektrische Signal-Leuchtenanordnungen werden beispielhaft in der WO 2010/012443 A1 oder auch der DE 202 04 003 U1 beschrieben. Signal-Schaltungsanordnungen bzw. Signal-Leuchtenanordnungen werden üblicherweise eingesetzt, um Signale zu erzeugen, die dazu dienen, auf etwaige Gefahren, Besonderheiten etc. hinzuweisen. Das kann mit Hilfe eines Leuchtmittels als elektrischem Bauteil und gleichsam optisch geschehen. Alternativ hierzu ist aber auch eine akustische Warnung denkbar, wenn als elektrisches Bauteil ein Lautsprecher zum Einsatz kommt. Daneben kann das fragliche elektrische Bauteil natürlich auch Hilfsfunktionen bei der Signalerzeugung übernehmen, beispielsweise als Verstärker, Spannungswandler etc. fungieren.

Signal-Schaltungsanordnungen werden meistens eingesetzt, um Fehler an Maschinen oder Anlagen zu melden und entsprechende Warnungen abzugeben. Darüber hinaus können beispielsweise Signalleuchten Fluchtwege anzeigen oder möglicherweise sogar auch auf Werbeflächen hinweisen. Vergleichbares gilt für akustische Signalgeräte.

Elektrische Signal-Schaltungsanordnungen werden oftmals in explosionsgefährdeten Bereichen eingesetzt. Hier kommt es primär darauf an, etwaige Wärmequellen beispielsweise in Gestalt des elektrischen Bauteils abzuschalten bzw. auf ein Minimum zu beschränken, um ein unter Umständen zündfähiges Gasgemisch nicht zur Explosion zu bringen. Zu diesem Zweck arbeitet man in der Praxis oftmals mit ausladenden Gehäusen, die zudem druckfest ausgelegt sind. Tatsächlich spricht der gattungsbildende Stand der Technik nach der DE 202 04 003 U1 zwar ein in ein zugehöriges Gehäuse eingebrachtes Gießharz als Vergussmasse an. Allerdings wird zusätzlich eine in einem Leuchtstab angeordnete Leuchtdiode beschrieben, wobei der fragliche Leuchtstab im Sinne des Explosionsschutzes als Vergusskapselung ausgebildet ist.

Daraus resultieren nicht unerhebliche Kosten und ein dementsprechender Aufwand bei der Herstellung. Denn der Leuchtstab zur Aufnahme der Leuchtdiode muss separat hergestellt und im Innern des Gehäuses platziert werden. Erst dann kann das Gießharz in das Gehäuse eingefüllt werden.

Bei der gattungsbildenden elektrischen Signal-Schaltungsanordnung entsprechend der WO 02/13585 A2 wird so vorgegangen, dass die elektrische Schaltung mit einer Schutzschicht bedeckt ist, welche erste und zweite Bereiche aufweist. Dabei sind die ersten Bereiche weicher als die zweiten Bereiche ausgelegt. Auf dieses Weise wird eine Schutzschicht bereitgestellt, die hinsichtlich mechanischer und thermischer Belastbarkeit optimiert ist. Allerdings ist die Konstruktion relativ aufwendig, weil die Schutzschicht aus Gelmaterialien aufgebaut ist. Außerdem muss das Gel durch Erwärmung der gesamten Anordnung ausgehärtet werden, was möglicherweise die Funktionsfähigkeit des elektrischen Bauteils beeinträchtigt oder beeinträchtigen kann. Hier will die Erfindung insgesamt Abhilfe schaffen.

Der Erfindung liegt das technische Problem zugrunde, eine derartige elektrische Signal-Schaltungsanordnung und vorzugsweise eine elektrische Signal-Leuchtenanordnung so weiter zu entwickeln, dass der konstruktive Aufwand verringert ist und die Herstellungskosten minimiert werden.

Zur Lösung dieser technischen Problemstellung ist eine gattungsgemäße elektrische Signal-Schaltungsanordnung und vorzugsweise eine elektrische Signal-Leuchtenanordnung dadurch gekennzeichnet, dass das mit der Trennschicht beschichtete elektrische Bauteil in das Innere des Gehäuses eingesetzt und das Gehäuse anschließend teilweise oder vollständig mit der Vergussmasse ausgefüllt wird. Darüber hinaus kann eine weitere Trennschicht optional zwischen der Vergussmasse und dem Gehäuse vorgesehen werden.

Die Erfindung greift also im Gegensatz zu der DE 202 04 003 U1 nicht auf eine explosionsgeschützte Kapsel zurück, welche das im Innern des Gehäuses angeordnete elektrische Bauteil umgibt. Dadurch können die Herstellungskosten bereits minimiert werden und ist der Aufwand deutlich verringert. Vielmehr wird das fragliche elektrische Bauteil mittelbar unter Zwischenschaltung der Trennschicht mit der Vergussmasse verbunden bzw. in der Vergussmasse aufgenommen. Die Vergussmasse ihrerseits ist gegebenenfalls unter Zwischenschaltung einer weiteren Trennschicht mit dem Gehäuse verbunden.

Darüber hinaus liegt es im Rahmen der Erfindung, wenn das elektrische Bauteil in die Vergussmasse eingebettet ist und zugleich eine Trennschicht zwischen der Vergussmasse und dem Gehäuse realisiert wird. Jedenfalls ist - wenn man einen Querschnitt durch das Gehäuse vom meistens mittig im Innern angeordneten elektrischen Bauteil ausgehend bis zum Rand betrachtet - zwischen dem elektrischen Bauteil und dem Gehäuse immer die Vergussmasse realisiert, und zwar in Verbindung mit wenigstens einer Trennschicht. Das heißt, es wird eine Konstruktion im Sinne von: elektrisches Bauteil - erste Trennschicht - Vergussmasse - zweite Trennschicht (meistens optional) - Gehäuse realisiert. Dabei ist wenigstens eine der beiden Trennschichten obligatorisch vorgesehen.

Auf diese Weise werden mehrere positive Effekte erreicht. Zunächst einmal erfährt das elektrische Bauteil eine hermetische Kapselung im Innern des Gehäuses, weil das Innere des Gehäuses vorteilhaft vollständig mit der Vergussmasse ausgefüllt ist. Da das elektrische Bauteil überwiegend so aus gelegt ist, dass seine Wärmeentwicklung überschaubar ist und im Übrigen die zwischengeschaltete Vergussmasse kaum Wärme leitet, ist nicht mit einer Erwärmung des Gehäuses außenseitig zu rechnen. Tatsächlich kommt an dieser Stelle als elektrisches Bauteil meistens ein Leuchtmittel und hier ein oder mehrere LED's, insbesondere Weißlicht-LED's zum Einsatz. Derartige LED's zeichnen sich durch einen hohen Wirkungsgrad in Verbindung mit geringer Wärmeentwicklung aus, erfüllen also die zuvor angegebene Bedingung.

Da das elektrische Bauteil vollständig von der Vergussmasse eingeschlossen wird, müssen von der elektrischen Signal-Schaltungsanordnung insgesamt Temperaturausdehnungen und -schrumpfungen aufgenommen werden. Denn der Anwendungsbereich der betreffenden Signal-Schaltungsanordnung überstreicht ein Temperaturregime im Bereich von ca. -60 °C bis ca. 200 °C. Um an dieser Stelle unterschiedliche Wärmeausdehnungskoeffizienten von einerseits dem elektrischen Bauteil und andererseits dem Gehäuse sowie der Vergussmasse auszugleichen, ist erfindungsgemäß die fragliche zumindest eine Trennschicht zwischen dem elektrischen Bauteil und der Vergussmasse bzw. der Vergussmasse und dem Gehäuse zwischengeschaltet. Hierdurch fungiert die Trennschicht also derart, dass temperaturbedingte Volumenänderungen zwischen dem elektrischen Bauteil und der Vergussmasse und/oder zwischen der Vergussmasse und dem Gehäuse ausgeglichen werden.

Das erreicht die Erfindung auf verschiedene Arten und Weisen. So ist es möglich, die Trennschicht im Rahmen einer ersten Variante hohl auszubilden. Bei einer Alternative schlägt die Erfindung vor, dass die Trennschicht mit einem elastischen bzw. weichelastischen Material ausgefüllt ist. Dieses elastische Material besitzt im Regelfall eine Shore-A-Härte von maximal 100. Das gilt jedenfalls für den bereits angesprochenen und wesentlichen Temperaturbereich von -60 °C bis ca. 200 °C. Dabei hat sich der Rückgriff auf elastomere Kunststoffe zur Realisierung der Trennschicht als besonders günstig erwiesen. Tatsächlich ist das fragliche elastische Material überwiegend als Silikonelastomer und insbesondere Slikonkautschuk ausgebildet. Außerdem hat es sich gezeigt, dass an dieser Stelle typischerweise Schichtdicken des elastischem Materials im Mikrometerbereich, meistens weniger als 500 µm und insbesondere weniger als 100 µm ausreichend sind.

Als Vergussmasse können grundsätzlich jedwede Kunststoffmassen zum Einsatz kommen, die sich als Gießharz in das Gehäuse einfüllen lassen und hierin aushärten. Tatsächlich verfügen derartige Vergussmassen im Regelfall über die erforderlichen elektrischen Isolationseigenschaften einerseits und sind oftmals durchsichtig gestaltet, was für ihre Anwendung in Verbindung mit einer elektrischen Signal-Leuchtenanordnung andererseits von besonderer Bedeutung ist. Denn in einem solchen Fall ist das Gehäuse meistens zweiteilig mit einer durchsichtigen Signalhaube und einem undurchsichtigen bzw. opaken Grundkörper ausgebildet. Damit das vom Leuchtmittel ausgesandte Licht durch die Vergussmasse hindurch aus der Signalhaube austreten kann, ist es erforderlich, dass die Vergussmasse gleichsam als Lichtleiter fungiert. Dabei können zusätzlich ein oder mehrere Inhomogenitäten in die Vergussmasse eingebracht werden, die als Streuzentren innerhalb der Vergussmasse fungieren und einen insgesamt homogenen gleichmäßigen Beleuchtungseindruck vermitteln.

Die fragliche Vergussmasse mag darüber hinaus mit einem UV-Stabilisator ausgerüstet werden, um etwaigen Veränderungen ihrer Struktur im Sonnenlicht vorzubeugen. Meistens kommt als Vergussmasse eine solche auf Basis von Polyurethan bzw. Polyurethangießharzen zum Einsatz. Tatsächlich eignet sich Polyurethan für den fraglichen Verwendungszweck als Vergussmasse besonders, weil Polyurethane sowohl hart als auch weich und elastisch hergestellt und ausgelegt werden können. Das hängt von der Wahl der PolyolKomponente ab. Dadurch lassen sich die Polyurethane im Kern so herstellen, dass ihre Elastizität bzw. Härte vom Shore-A- bis in den Shore-D-Bereich angesiedelt ist. Es lassen sich also sowohl weichelastische Polyurethanvergussmassen als auch hartelastische Polyurethanvergussmassen realisieren. Das ist für den beschriebenen Einsatzzweck von besonderer Bedeutung.

Denn wie bereits dargelegt, ist das Gehäuse der erfindungsgemäßen elektrischen Signal-Schaltungsanordnung meistens zweiteilig mit der durchsichtigen Signalhaube und dem opaken Grundkörper ausgebildet. Dabei arbeitet man überwiegend mit zwei verschiedenen Vergussmassen im Innern des fraglichen Gehäuses. Tatsächlich wird die Signalhaube größtenteils mit der ersten Vergussmasse gefüllt, während der Grundkörper überwiegend die zweite Vergussmasse beinhaltet.

In diesem Zusammenhang ist die Auslegung im Regelfall so getroffen, dass die erste Vergussmasse weich bzw. weichelastisch ausgelegt ist, um etwaige Beschädigungen der Signalhaube aufnehmen zu können. In einem solchen Fall kommt meistens ein Polyurethangießharz zum Einsatz, welches eine vergleichbare Shore-A-Härte wie die elastische Trennschicht aufweist, also im Bereich von ca. 70 bis 100 angesiedelt ist.

Auf diese Weise ist die Signalhaube in Verbindung mit der ersten weichelastischen Vergussmasse in der Lage, insbesondere etwaige Schlagbeanspruchungen aufnehmen zu können, ohne dass die Vergussmasse im Innern eine Zerstörung erfährt, selbst dann nicht, wenn die Signalhaube als solches zersplittert oder gerissen ist. Das ist von besonderer Bedeutung, um zu verhindern, dass beispielsweise explosionsfähiges Gemisch im Bereich der erfindungsgemäßen Signal-Schaltungsanordnung durch die zerstörte Signalhaube hindurch bis hin zum (mehr oder minder heißen) Leuchtmittel gelangt und hier möglicherweise die Zündtemperatur überschritten wird. Wie beschrieben verhindert der erfindungsgemäße Aufbau ein solches Szenario, weil im Bereich der fraglichen Signal haube die Vergussmasse mit dem beschriebenen weichelastischen Charakter zum Einsatz kommt und Stoßbelastungen beschädigungsfrei aufnimmt.

Dagegen ist die zweite und im opaken Grundkörper eingesetzte Vergussmasse überwiegend hartelastisch ausgelegt und verfügt beispielsweise über eine Shore-D-Härte von mehr als 20 bis hin zu 70. Diese unterschiedlichen Härtegrade lassen sich mit verschiedenen Polyurethanen beispielsweise auf Basis von Polyesterurethan problemlos realisieren.

Aufgrund der unterschiedlichen Auslegung der Vergussmassen, und zwar einerseits weichelastisch und andererseits hartelastisch, stellen sich auch verschiedene Längen- bzw. Volumenausdehnungskoeffizienten zwischen der 1. und der 2. Vergussmasse und insbesondere zwischen der Vergussmasse und dem elektrischen Bauteil ein. Tatsächlich beobachtet man für typische Polyurethane Längenausdehnungskoeffizienten von beispielsweise 70 x 10⁻⁶/K. Dagegen werden für Metalle als Grundkörper zur Aufnahme der Leuchtdioden als elektrischem Bauteil Längenausdehnungskoeffizienten im Bereich von ca. 20 x 10⁻⁶/K beobachtet. Um diese unterschiedlichen Längen- und folglich auch Volumenausdehnungskoeffizienten über den gesamten Anwendungsbereich von ca. -60 °C bis ca. 200 °C der erfindungsgemäßen elektrischen Signal-Schaltungsanordnung ohne Verspannungen und Risse darstellen zu können, ist die erfindungsgemäß vorgesehene wenigstens eine Trennschicht realisiert, in welcher vorteilhaft das weichelastische Material auf Basis von Silikonelastomeren zum Einsatz kommt. Tatsächlich gleicht die fragliche Trennschicht den skizzierten Unterschied in den Ausdehnungskoeffizienten problemlos aus, so dass die erfindungsgemäße elektrische Signal-Schaltungsanordnung über den gesamten Temperaturbereich eingesetzt werden kann, ohne dass Risse, Verspannungen etc. auftreten.

In diesem Zusammenhang ist es zusätzlich noch von besonderer Bedeutung, dass die erste Vergussmasse und die zweite Vergussmasse durch eine weitere Trennschicht voneinander separiert sind. Meistens verfügt die erste Vergussmasse deutlich höherer Elastizität im Vergleich zur zweiten Vergussmasse niedrigerer Elastizität über einen korrespondierenden größeren Volumenausdehnungskoeffizienten im Vergleich zur zweiten Vergussmasse. Um diesen erfindungsgemäß aufzufangen bzw. ausgleichen zu können ist die zwischen der ersten und der zweiten Vergussmasse vorgesehene weitere Trennschicht realisiert. Dabei mag diese Trennschicht erneut unter Rückgriff auf ein Silikonelastomer mit der beschriebenen Schichtdicke von weniger als 500 µm ausgelegt werden.

Jedenfalls wird erfindungsgemäß eine elektrische Signal-Schaltungsanordnung zur Verfügung gestellt, die zunächst einmal durch einen äußerst einfachen und kostengünstigen Aufbau überzeugt. Denn das gesamte Innere des Gehäuses ist regelmäßig vollständig mit der Vergussmasse ausgefüllt. Da als elektrisches Bauteil überwiegend ein Leuchtmittel und hier eine oder mehrere LED's zum Einsatz kommen, kommt der Auslegung der Signalhaube eine besondere Bedeutung zu. Denn es muss sichergestellt werden, dass selbst bei einer Beschädigung der Signalhaube etwaige explosionsgefährdete Gase in der Umgebung nicht bis hin zum Leuchtmittel als solchem vordringen können.

Das gewährleistet die Erfindung im Kern dadurch, dass im Bereich der Signalhaube mit einer ersten Vergussmasse gearbeitet wird, die über eine weichelastische Auslegung mit einer Shore-A-Härte von 100 oder weniger arbeitet. Dadurch werden beispielsweise Schlagbeanspruchungen problemlos von der ersten Vergussmasse aufgenommen und führen an dieser Stelle nicht zu Rissen oder dergleichen. Das im Innern der ersten Vergussmasse befindliche Leuchtmittel ist also nach wie vor auch bei einer solchen Beschädigung hermetisch von der Umgebung abgeschlossen.

Demgegenüber kann im Bereich des Grundkörpers des Gehäuses mit einer überwiegend hartelastischen Vergussmasse gearbeitet werden. Diese verfügt über eine Shore-D-Härte von mehr als 50 und bis zu 70. Um die unterschiedlichen Härtegrade von einerseits der ersten Vergussmasse und andererseits der zweiten Vergussmasse und damit verbundene variierende Wärmeausdehnungskoeffizienten auffangen zu können, ist zwischen den beiden Vergussmassen die bereits angesprochene Trennschicht vorgesehen. Ebenfalls findet sich eine Trennschicht zwischen dem elektrischen Bauteil und der ersten Vergussmasse und/oder zwischen der ersten Vergussmasse und dem Gehäuse bzw. der Signalhaube.

Dadurch werden insgesamt Verspannungen innerhalb des Einsatzbereiches von ca. -60 °C bis ca. 200 °C vermieden und wird zugleich eine explosionsgeschützte Auslegung geschaffen, die auf zusätzlich eingebrachte Kapseln oder dergleichen ausdrücklich verzichtet. Dadurch lassen sich die Herstellungskosten besonders niedrig halten. Tatsächlich erfolgt die Fertigung dergestalt, dass zunächst das elektrische Bauteil in das Gehäuse bzw. in dessen Inneres eingesetzt wird. Zuvor wird das fragliche elektrische Bauteil vorteilhaft mit einer Trennschicht aus dem weichelastischen Material ausgerüstet. Anschließend wird das Gehäuse teilweise oder vollständig mit der einen oder mit den beiden Vergussmassen ausgefüllt.

Sofern zwei Vergussmassen zum Einsatz kommen, wird zunächst die erste Vergussmasse über Kopf in die Signalhaube eingefüllt. Danach wird die Trennschicht aufgebracht. Im Anschluss daran wird die zweite Vergussmasse in den noch auszufüllenden Grundkörper eingebracht. Hierin sind die wesentlichen Vorteile zu sehen.

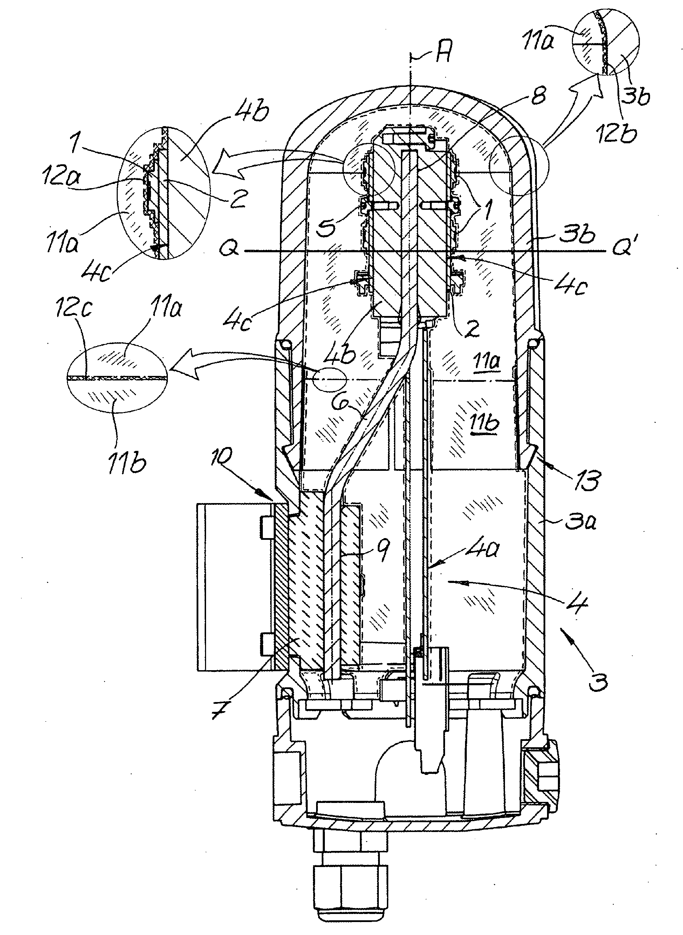

Im Folgenden wird die Erfindung anhand einer lediglich ein Ausführungsbeispiel darstellenden Zeichnung näher erläutert. Die einzige Figur zeigt eine erfindungsgemäße elektrische Schaltungsanordnung in einer Übersicht.

In der einzigen Figur ist eine elektrische Signal-Schaltungsanordnung in der Ausführungsform als elektrische Signal-Leuchtenanordnung dargestellt. Zum grundsätzlichen Aufbau der Signal-Leuchtenanordnung bzw. der Signalleuchte im Ausführungsbeispiel gehören ein bzw. mehrere elektrische Bauteile 1, bei denen es sich vorliegend jeweils um LED's 1 handelt. Diese Bauteile 1 bzw. LED's 1 werden auf einer aus einem wärmeleitenden Material gefertigte Leiterplatte 2 aufgenommen. Die Leiterplatte 2 ist im Ausführungsbeispiel aus einem Metall, insbesondere Aluminium, hergestellt. Bei den LED's 1 handelt es sich um SMD-LED's 1 und hier um SMD-Weißlicht-LED's 1.

Die LED's bzw. Leuchtmittel 1 sind kreisförmig im Vergleich zu einer zentralen Achse A eines Gehäuses 3 angeordnet. Gegenüber dieser Achse A ist das Gehäuse 3 rotationssymmetrisch ausgeführt. Auf diese Weise wird das von den LED's bzw. Leuchtmitteln 1 abgestrahlte Licht in sämtliche Raumrichtungen ausgestrahlt, so dass eine Rundum-Lichtabstrahlung gewährleistet ist.

Die jeweilige Leiterplatte 2 wird von einem Gehäuseeinsatz 4 getragen, der seinerseits mit dem Gehäuse 3 mechanisch verbunden ist. Der Gehäuseeinsatz 4 setzt sich aus einem Einsatzfuß 4a und einem Einsatzkopf 4b zusammen. Der Einsatzkopf 4b ist im Querschnitt als Vieleck mit Seitenflächen 4c ausgerüstet, die jeweils eine Leiterplatte 2 tragen. Dazu ist die jeweilige Leiterplatte 2 mit Hilfe einer oder mehrerer Schrauben 5 mit dem Einsatzkopf 4 verbunden.

Mit der Leiterplatte 2 steht im Beispiel eine Kühleinrichtung 6, 7 in Wärmekontakt, die sich vorliegend aus einem Wärmerohr 6 und einem Kühlkörper 7 zusammensetzt. Das Wärmerohr 6 verbindet die jeweilige Leiterplatte 2 thermisch mit dem hiervon räumlich entfernt angeordneten Kühlkörper 7. Zu diesem Zweck wird das Wärmerohr 6 zentral im Einsatzkopf 4b des Gehäuseeinsatzes 4 aufgenommen. Zu diesem Zweck ist eine Hohlbohrung 8 im Einsatzkopf 4b und auch eine Hohlbohrung 9 im Kühlkörper 7 vorgesehen. Folglich fließt von den LED's 1 produzierte Verlustwärme über den Einsatzkopf 4b, das Wärmerohr 6 schließlich zum Kühlkörper 7, der als Wärmesenke fungiert. Schließlich erkennt man in der einzigen Figur noch eine Gehäuseausnehmung 10, in welcher der Kühlkörper 7 platziert ist. Dadurch befindet sich der Kühlkörper 7 unmittelbar in Wärmekontakt mit der Umgebungsatmosphäre. Das ist vor dem Hintergrund von besonderer Bedeutung, als das Gehäuse 3 im Ausführungsbeispiel aus Kunststoff und hier einem thermoplastischen Kunststoff hergestellt ist, folglich über eine schlechte Wärmeleitung verfügt.

Das Gehäuse 3 ist vorliegend im Wesentlichen zweiteilig mit einem opaken Grundkörper 3a und einer durchsichtigen Signalhaube 3b ausgebildet. In Folge der transparenten Signalhaube 3b kann das von den LED's 1 abgegebene Licht rundum problemlos abgestrahlt werden und sorgt für die gewünschte Signalwirkung. Hierzu trägt ergänzend der Umstand bei, dass das Gehäuse 3 mit einer Vergussmasse 11 a, 11 b im Innern gefüllt ist, und zwar im Rahmen des Ausführungsbeispiels vollständig. Dabei ist wenigstens die erste Vergussmasse 11a im Bereich der Signalhaube 3b transparent ausgelegt.

Anhand der vergrößerten Darstellungen in der einzigen Figur erkennt man, dass zwischen dem elektrischen Bauteil bzw. der LED 1 einerseits und der Vergussmasse 11a, 11 b andererseits eine erste Trennschicht 12a vorgesehen ist. Darüber hinaus mag noch eine zweite Trennschicht 12b zwischen der Vergussmasse 11a, 11b und dem Gehäuse 3 respektive der Signalhaube 3b vorgesehen werden. Das heißt, über den Querschnitt Q bzw. den Halbquerschnitt Q' von der zentralen Achse A bis hin zum Gehäuse 3 bzw. der Signalhaube 3b gesehen, ist wenigstens eine Trennschicht 12a oder 12b oder sind zwei Trennschichten 12a und 12b vorgesehen.

Neben der ersten Trennschicht 12a und der zweiten Trennschicht 12b findet sich noch eine dritte Trennschicht 12c die zwischen der ersten Vergussmasse 11a und der zweiten Vergussmasse 11 b zwischengeschaltet ist. Das machen jeweils die vergrößerten Detailausschnitte in der einzigen Figur deutlich. Mit Hilfe dieser jeweiligen Trennschichten 12a, 12b, 12c lassen sich Volumenänderungen ausgleichen, die aufgrund unterschiedlicher Wärmeausdehnungskoeffizienten der aneinander anliegenden Bauteile respektive Elemente verursacht werden, folglich temperaturbedingt vorliegen.

Tatsächlich verfügt das elektrische Bauteil 1 bzw. dessen Leiterplatte 2 aus Aluminium über einen Volumenausdehnungskoeffizienten, welcher typischerweise lediglich ein Drittel desjenigen der umgebenden ersten Vergussmasse 11a beträgt. Um an dieser Stelle Spannungen oder Risse aufzufangen, sind die erste Trennschicht 12a und/oder die zweite Trennschicht 12b vorgesehen. Vergleichbares mag für den Übergang von der Vergussmasse 11a, 11 b zum Gehäuse 3 gelten. Denn die Vergussmasse verfügt - wie einleitend bereits dargelegt - über einen Längenausdehnungskoeffizienten von ca. 70 x 10⁻⁶/K, wohingegen das Gehäuse aus einem thermoplastischen Kunststoff wie beispielsweise Polyethylen (PE) oder auch Polyamid (PA) typischerweise mit Längenausdehnungskoeffizienten im Bereich von 100 bis 200 x 10⁻⁶/K ausgerüstet ist. Das heißt, die Ausdehnung des Gehäuses 3 ist größer, teilweise sogar doppelt so groß wie diejenige der Vergussmasse 11a, 11b. Noch deutlich größer ist jedoch der Unterschied in den Volumenausdehnungskoeffizienten von einerseits dem elektrischen Bauteil 1 und der Vergussmasse 11a, 11b.

Jedenfalls lassen sich diese unterschiedlichen Ausdehnungskoeffizienten durch die jeweilige Trennschicht 12a, 12b, 12c wie einleitend bereits beschrieben ausgleichen. Zu diesem Zweck ist die Trennschicht 12a, 12b, 12c mit einem weichelastischen Material einer Shore-A-Härte von maximal 100 ausgefüllt. Tatsächlich kommt als Material für die Trennschicht 12a, 12b, 12c im Regelfall ein Silikonelastomer und hier insbesondere Silikonkautschuk zum Einsatz. Ein derartiger Werkstoff behält seine Elastizität im fraglichen Temperaturbereich von -60 °C bis ca. 200 °C im Wesentlichen bei, kann also temperaturbedingte unterschiedliche Ausdehnungen zwischen den benachbarten Elementen problemlos ausgleichen.

Bei diesen benachbarten Elementen handelt es sich im Falle der ersten Trennschicht 12a um einerseits die LED 1 bzw. die Leiterplatte 2 aus Aluminium und andererseits die die LED's 1 aufnehmende und umhüllende Vergussmasse 11a. Bei der zweiten Trennschicht 12b werden etwaige Volumenänderungen zwischen der ersten Vergussmasse 11a und dem Gehäuse 3 respektive der Signalhaube 3b aufgenommen. Die dritte Trennschicht 12c gleicht schließlich temperaturbedingte Änderungen in der Volumenausdehnung zwischen den beiden Vergussmassen 11a, 11b aus.

Die Schichtdicke der jeweiligen Trennschicht 12a, 12b, 12c liegt typischerweise unterhalb von 500 µm, im Regelfall beträgt sie weniger als 100 µm. Außerdem erkennt man anhand der Darstellung, dass das Gehäuse 3 vollständig mit der betreffenden Vergussmasse 11a, 11b ausgefüllt ist. Dabei sind jeweils verschiedene Vergussmassen 11a, 11b mit unterschiedlicher Festigkeit realisiert. Die erste Vergussmasse 11a verfügt im Beispielfall über eine Shore-A-Härte im Bereich von 70 bis 100. Sie ist folglich weichelastisch. Die zweite Vergussmasse 11 b ist dagegen hartelastisch ausgelegt und verfügt über eine Shore-D-Härte von ca. 50 bis 70.

Man erkennt, dass die Signalhaube 3b überwiegend mit der ersten Vergussmasse 11a verbunden ist, während der Grundkörper 3a größtenteils die zweite Vergussmasse 11 b aufnimmt. Da die dritte Trennschicht 12c zwischen der ersten Vergussmasse 11a und der zweiten Vergussmasse 11 b im unteren Bereich der Signalhaube 3b angesiedelt ist und die zweite Vergussmasse 11 b bis in den Grundkörper 3a hineinragt, wird nach Ausfüllen des Gehäuses 3 und Erhärten der fraglichen Vergussmassen 11a, 11 b zugleich erreicht, dass die Signalhaube 3b und der Grundkörper 3a untrennbar miteinander verbunden sind.

Zur Herstellung der erfindungsgemäßen elektrischen Signalschaltungsanordnung wird so vorgegangen, dass zunächst das Leuchtmittel 1 gegebenenfalls in Verbindung mit der das Leuchtmittel 1 aufnehmenden Leiterplatte 2 mit der Trennschicht bzw. der ersten Trennschicht 12a ausgerüstet wird. Zu diesem Zweck mag die erste Trennschicht 12a durch Sprühen, Eintauchen der Leiterplatte 2 mit den Leuchtmitteln 1 in eine Lösung etc. aufgebracht werden. Anschließend wird der zugehörige Gehäuseeinsatz 4 zusammen mit dem Kühlkörper 7 im Gehäuse 3 verschraubt, indem der Kühlkörper 7 in der Gehäuseausnehmung 10 platziert wird. Danach wird das Gehäuse 3 in eine Überkopfstellung gebracht, und zwar bei montiertem Gehäuseansatz 4, angebrachten LED's 1 und ebenfalls realisierter Kühleinrichtung 6, 7.

In dieser Überkopfstellung wird zunächst die erste Vergussmasse 11a in zähflüssigem Zustand in das Gehäuse 3 eingefüllt, und zwar bis ein Flüssigkeitsniveau erreicht ist, dass in der einzigen Figur strichpunktiert angedeutet wurde. Zuvor sind der opake Grundkörper 3a und die durchsichtige Signalhaube 3b über jeweilige Rastverbindungen 13 miteinander gekoppelt worden oder gehen eine gegenseitige Steckverbindung ein.

Nachdem die erste Vergussmasse 11a eingefüllt worden und ausgehärtet ist, wird die dritte Trennschicht 12c auf die ausgehärtete erste Vergussmasse 11a aufgebracht. Im Anschluss daran wird die zweite Vergussmasse 11b in das Gehäuse 3 eingefüllt. Bei der beschriebenen Herstellung ist die zweite Trennschicht 12b ausgespart worden, weil diese in der Regel entbehrlich ist. Das lässt sich auf das vergleichbare Wärmeausdehnungsverhalten von einerseits der Vergussmasse 11a, 11b und andererseits dem Gehäuse 3 zurückführen.

Insbesondere die erste Trennschicht 12a (und natürlich auch die zweite bzw. dritte Trennschicht 12b, 12c) sorgen nicht nur dafür, dass etwaige unterschiedliche Wärmeausdehnungen aufgenommen werden. Sondern die fragliche Trennschicht 12a, 12b,12c führt auch dazu, dass etwaige Ecken und Kanten im Bereich der Trennschicht abgerundet werden. Das ist insbesondere beim Überzug der Leuchtmittel 1 respektive der die Leuchtmittel 1 aufnehmende Leiterplatte 2 insofern von besonderer Bedeutung, als durch diese Abrundung etwaige mechanische Spannungsspitzen (Kerbspannung) bei der Ausdehnung und Schrumpfung im Grenzbereich zwischen dem Leuchtmittel 1 bzw. dem Kühlkörper 2 und der umgebenden Vergussmasse 11a vermieden werden.

## Patentansprüche

1. Elektrische Signal-Schaltungsanordnung, vorzugsweise elektrische Signal-Leuchtenanordnung, zum Einsatz in explosionsgefährdeten Bereichen, mit einem Gehäuse (3), und mit zumindest einem in dem Gehäuse (3) angeordneten elektrischen Bauteil (1), insbesondere Leuchtmittel (1), wobei
- das Innere des Gehäuses (3) wenigstens teilweise mit einer Vergussmasse (11 a, 11 b) ausgefüllt ist, und wobei
- wenigstens zwischen dem elektrischen Bauteil (1) und der Vergussmasse (11a, 11b) eine temperaturbedingte Volumenänderungen ausgleichende Trennschicht (12a) vorgesehen ist,
**dadurch gekennzeichnet, dass**
- das mit der Trennschicht (12a) beschichtete elektrische Bauteil (1) in das Innere des Gehäuses (3) eingesetzt und das Gehäuse (3) anschließend teilweise oder vollständig mit der Vergussmasse (11 a, 11 b) ausgefüllt wird.

2. Anordnung nach Anspruch 1, **dadurch gekennzeichnet, dass** zusätzlich zwischen der Vergussmasse (11a, 11 b) und dem Gehäuse (3) eine weitere Trennschicht (12b, 12c) vorgesehen ist.

3. Anordnung nach Anspruch 1 oder 2, **dadurch gekennzeichnet, dass** die Trennschicht (12a, 12b, 12c) hohl ausgebildet ist.

4. Anordnung nach einem der Ansprüche 1 bis 3, **dadurch gekennzeichnet, dass** die Trennschicht (12a, 12b, 12c) mit einem elastischen Material einer Shore-A-Härte von maximal 100 ausgefüllt ist.

5. Anordnung nach Anspruch 4, **dadurch gekennzeichnet, dass** das elastische Material als Silikonelastomer, insbesondere Silikonkautschuk, ausgebildet ist.

6. Anordnung nach einem der Ansprüche 1 bis 5, **dadurch gekennzeichnet, dass** die Trennschicht (12a, 12b, 12c) eine Schichtdicke kleiner 500 µm, insbesondere kleiner 100 µm, aufweist.

7. Anordnung nach einem der Ansprüche 1 bis 6, **dadurch gekennzeichnet, dass** das Gehäuse (3) vollständig mit der Vergussmasse (11a, 11b) ausgefüllt ist.

8. Anordnung nach einem der Ansprüche 1 bis 7, **dadurch gekennzeichnet, dass** zwei verschiedene Vergussmassen (11a, 11 b) mit unterschiedlicher Festigkeit realisiert sind.

9. Anordnung nach einem der Ansprüche 1 bis 8, **dadurch gekennzeichnet, dass** eine erste Vergussmasse (11a) und eine zweite Vergussmasse (11 b) durch eine weitere Trennschicht (12c) voneinander separiert sind.

10. Anordnung nach einem der Ansprüche 1 bis 9, **dadurch gekennzeichnet, dass** das Gehäuse (3) aus einem Kunststoff, insbesondere einem thermoplastischen Kunststoff, hergestellt ist.

11. Anordnung nach einem der Ansprüche 1 bis 10, **dadurch gekennzeichnet, dass** das Gehäuse (3) zweiteilig mit Signalhaube (3b) und Grundkörper (3a) ausgebildet ist.

12. Anordnung nach Anspruch 11, **dadurch gekennzeichnet, dass** die Signalhaube (3b) überwiegend mit der ersten Vergussmasse (11a) ausgefüllt ist, während der Grundkörper (3a) überwiegend die zweite Vergussmasse (11 b) beinhaltet.

13. Anordnung nach einem der Ansprüche 1 bis 12, **dadurch gekennzeichnet, dass** die Vergussmasse (11a, 11 b) auf Basis von Polyurethan, insbesondere Polyurethangießharzen, hergestellt ist.

14. Verfahren zur Herstellung einer elektrischen Signal-Schaltungsanordnung, vorzugsweise einer elektrischen Signal-Leuchtenanordnung, zum Einsatz in explosionsgefährdeten Bereichen, mit folgenden Verfahrensschritten:
14.1) ein elektrisches Bauteil (1), insbesondere Leuchtmittel (1), und/oder das Innere eines Gehäuses (3) werden mit einer Trennschicht (12a, 12b) aus einem weichelastischen Material beschichtet;
14.2) das elektrische Bauteil (1) wird im Innern des Gehäuses (3) platziert;
14.3) das Gehäuse (3) wird mit einer Vergussmasse (11a, 11b) ganz oder teilweise ausgefüllt.

15. Verfahren nach Anspruch 14, **dadurch gekennzeichnet, dass** in das Gehäuse (3) zunächst eine erste Vergussmasse (11a) und nach deren Aushärten eine zweite Vergussmasse (11 b) unter Zwischenschaltung einer weiteren Trennschicht (12c) eingefüllt wird.

## Claims

1. Electrical signal circuit, preferably electrical signal light assembly, for use in potentially explosive areas, comprising a housing (3) and comprising at least one electrical component (1), in particular a lighting means (1), arranged in the housing (3),
- the interior of the housing (3) being at least partially filled with a casting compound (11 a, 11 b), and
- a separating layer (12a) being provided at least between the electrical component (1) and the casting compound (11 a, 11 b), said separating layer compensating for temperature-related volume alterations,
**characterised in that**
- the electrical component (1) coated with the separating layer (12a) is inserted into the interior of the housing (3) and the housing (3) is then partially or completely filled with the casting compound (11 a, 11b).

2. Arrangement according to Claim 1, **characterised in that** a further separating layer (12b, 12c) is additionally provided between the casting compound (11 a, 11 b) and the housing (3).

3. Arrangement according to Claim 1 or 2, **characterised in that** the separating layer (12a, 12b, 12c) is of hollow configuration.

4. Arrangement according to one of Claims 1 to 3, **characterised in that** the separating layer (12a, 12b, 12c) is filled with an elastic material having a maximum Shore A hardness of 100.

5. Arrangement according to Claim 4, **characterised in that** the elastic material is configured as silicone elastomer, in particular silicone rubber.

6. Arrangement according to one of Claims 1 to 5, **characterised in that** the separating layer (12a, 12b, 12c) has a layer thickness of less than 500 µm, in particular of less than 100 µm.

7. Arrangement according to one of Claims 1 to 6, **characterised in that** the housing (3) is completely filled with the casting compound (11 a, 11 b).

8. Arrangement according to one of Claims 1 to 7, **characterised in that** two different casting compounds (11a, 11 b) of different strengths are produced.

9. Arrangement according to one of Claims 1 to 8, **characterised in that** a first casting compound (11 a) and a second casting compound (11 b) are separated from one another by a further separating layer (12c).

10. Arrangement according to one of Claims 1 to 9, **characterised in that** the housing (3) is produced from a plastics material, in particular a thermoplastic material.

11. Arrangement according to one of Claims 1 to 10, **characterised in that** the housing (3) is formed in two parts with a signal cover (3b) and a base body (3a).

12. Arrangement according to Claim 11, **characterised in that** the signal cover (3b) is primarily filled with the first casting compound (11 a), whilst the base body (3a) primarily contains the second casting compound (11 b).

13. Arrangement according to one of Claims 1 to 12, **characterised in that** the casting compound (11a, 11 b) is produced by being based on polyurethane, in particular polyurethane casting resin.

14. Method for producing an electrical signal circuit, preferably an electrical signal light assembly, for use in potentially explosive areas, comprising the following method steps:
14.1) an electrical component (1), in particular a lighting means (1) and/or the interior of a housing (3) are coated with a separating layer (12a, 12b) made of a soft elastic material;
14.2) the electrical component (1) is placed in the interior of the housing (3),
14.3) the housing (3) is entirely or partially filled with a casting compound (11 a, 11 b).

15. Method according to Claim 14, **characterised in that** initially a first casting compound (11 a) is filled into the housing (3) and, after the curing thereof, a second casting compound (11 b) is filled into said housing, with the interposition of a further separating layer (12c).

## Revendications

1. Dispositif de circuit de signalisation électrique, de préférence dispositif de lampe de signalisation électrique, à utiliser dans des zones sujettes aux explosions, comportant un logement (3) et au moins un composant électrique (1) disposé dans le logement (3), notamment un moyen lumineux (1), dans lequel
- l'intérieur du logement (3) est rempli au moins partiellement par une masse coulée (11 a, 11 b), et dans lequel
- au moins entre le composant électrique (1) et la masse coulée (1 1 a, 11 b), une couche de séparation (12a) compensant les variations de volume conditionnées par la température est prévue,
**caractérisé en ce que**
- le composant électrique (1) revêtu de la couche de séparation (12a) est inséré à l'intérieur du logement (3) et le logement (3) est par la suite rempli partiellement ou en totalité avec la masse coulée (11 a, 11 b).

2. Dispositif selon la revendication 1, **caractérisé en ce qu'**une couche de séparation supplémentaire (12b, 12c) est prévue en outre entre la masse coulée (11 a, 11 b) et le logement (3).

3. Dispositif selon les revendications 1 ou 2, **caractérisé en ce que** la couche de séparation (12a, 12b, 12c) a une configuration creuse.

4. Dispositif selon une des revendications 1 à 3, **caractérisé en ce que** la couche de séparation (12a, 12b, 12c) est remplie avec un matériau élastique d'une dureté shore A maximale de 100.

5. Dispositif selon la revendication 4, **caractérisé en ce que** le matériau élastique est réalisé comme un élastomère de silicone, notamment un caoutchouc de silicone.

6. Dispositif selon une des revendications 1 à 5, **caractérisé en ce que** la couche de séparation (12a, 12b, 12c) présente une épaisseur de couche inférieure à 500 µm, notamment inférieure à 100 µm.

7. Dispositif selon une des revendications 1 à 6, **caractérisé en ce que** le logement (3) est complètement rempli avec la masse coulée (11a, 11 b).

8. Dispositif selon une des revendications 1 à 7, **caractérisé en ce que** deux masses coulées différentes (11a, 11 b) avec une fermeté différente sont réalisées.

9. Dispositif selon une des revendications 1 à 8, **caractérisé en ce que** une première masse coulée (11 a) et une deuxième masse coulée (11 b) sont séparées l'une de l'autre par une couche de séparation (12c) supplémentaire.

10. Dispositif selon une des revendications 1 à 9, **caractérisé en ce que** le logement (3) est fabriqué dans un plastique, notamment un plastique thermoplastique.

11. Dispositif selon une des revendications 1 à 10, **caractérisé en ce que** le logement (3) est conçu en deux parties avec un capot de signalisation (3b) et un corps de base (3a).

12. Dispositif selon la revendication 11, **caractérisé en ce que** le capot de signalisation (3b) est rempli principalement avec la première masse coulée (11a), alors que le corps de base (3a) contient principalement la deuxième masse coulée (11 b).

13. Dispositif selon une des revendications 1 à 12, **caractérisé en ce que** la masse coulée (1 1 a, 1 1 b) est fabriquée à base de polyuréthane, notamment de résine coulée de polyuréthane.

14. Procédé de fabrication d'un dispositif de circuit de signalisation électrique, de préférence d'un dispositif de lampe de signalisation électrique, à employer dans des zones sujettes aux explosions, comportant les étapes de procédé suivantes :
14.1) un composant électrique (1), notamment un moyen lumineux (1), et/ou l'intérieur d'un logement (3) sont revêtus avec une couche de séparation (12a, 12b) en un matériau élastique tendre ;
14.2) le composant électrique (1) est placé à l'intérieur du logement (3);
14.3) le logement (3) est rempli partiellement ou totalement avec une masse coulée (11 a, 11 b).

15. Procédé selon la revendication 14, **caractérisé en ce que** dans le logement (3) est injectée tout d'abord une première masse coulée (11 a) et après le durcissement de celle-ci une deuxième masse coulée (11 b) en intercalant une couche de séparation (12c) supplémentaire.
